# EUROPEAN PATENT APPLICATION

(11) **EP 4 600 675 A1**
(43) Date of publication of application: **13.08.2025**
(21) Application number: 23874734.9
(22) Date of filing: 27.09.2023
(51) Int. Cl.: G01R 31/385, G01R 31/00, G01R 31/382

(54) **CHARGE/DISCHARGE TEST SYSTEM**

(30) Priority: 07.10.2022 JP 2022162620
(71) Applicant: Tokyo Seimitsu Co., Ltd., Hachioji-shi, Tokyo 192-8515 (JP)
(72) Inventor: SODA, Yuya, Hachioji-shi, Tokyo 192-8515 (JP); WATANABE, Tatsuro, Hachioji-shi, Tokyo 192-8515 (JP)
(74) Representative: Grünecker Patent- und Rechtsanwälte PartG mbB
(86) International application number: PCT/JP2023/035142
(87) International publication number: WO 2024/075607

(57) **Abstract**

A charge/discharge test system includes: a plurality of charge/discharge test devices (12) configured to perform charging and discharging of charge/discharge targets (9); a switching circuit (14) capable of switching between combinations of electrical connection between one or more of the charge/discharge test devices (12) and one or more of the charge/discharge targets (9), and a control unit (16) configured to control the switching circuit (14) to execute switching between the combinations.

## Description

### BACKGROUND OF THE INVENTION

### Field of the Invention

The present invention relates to a charge/discharge system that executes a charge/discharge test on a charge/discharge target.

### Description of the Related Art

In recent years, hybrid cars, plug-in hybrid cars and electric cars have been widely used. Development of inexpensive driving batteries is a key to the distribution of such cars. Unlike batteries for consumers, such as mobile batteries, these batteries typically have capacities that are as large as several kW to several tens of kW. For this reason, significantly large power is required for charging and discharging of the batteries at the time of development and mass production tests of the batteries. The power required for charging and discharging may further increase in the future with advancement in the distribution of cars of these types. In addition, since multiple battery cells are used in combination in the cars of the types, there is a need for a charge/discharge test system capable of testing multiple battery cells in parallel.

A charge/discharge test system includes a plurality of charge/discharge test devices. An AC (Alternating Current) power supply is electrically connected to one ends of the charge/discharge test devices via an AC bus, and respective charge/discharge targets, such as batteries as objects of charge/discharge test, are electrically connected to the other ends of the charge/discharge test devices. Each charge/discharge test device includes, for example, a bidirectional AC/DC (Direct Current) converter and a bidirectional DC/DC converter. The charge/discharge test device controls charging and discharging including: charging of DC power (direct current) into a charge/discharge target; and discharging of DC power (direct current) from a charge/discharge target.

The charge/discharge test system has a measurement unit provided for each of the charge/discharge test devices. The measurement unit measures a voltage in a charge/discharge target and a current flowing through the charge/discharge test device.

### Citation List

### Patent Literature(s)

Patent Literature 1: Japanese Patent Application Laid-Open No. 2012-154793

### SUMMARY OF THE INVENTION

In a charge/discharge test system provided with charge/discharge test devices, for example, the number of connections of charge/discharge units (e.g., the charge/discharge test devices or bidirectional DC/DC converters) electrically connected to the one charge/discharge targe may be increased so as to increase a current capacity with which one charge/discharge target may be charged and discharged . As an example, assume a case where one charge/discharge test device can charge or discharge a charge/discharge target with a current of 120 A. Electrical connection of M (M is an arbitrary natural number) number of charge/discharge units to one charge/discharge target allows charging and discharging of the one charge/discharge target with a current capacity of 120 A × M.

However, in a conventional charge/discharge test system, each time when the number of connections of charge/discharge units is changed, a connection relation between charge/discharge units and a charge/discharge target must be manually changed, and a correction values are required to correct measurement values of voltage and current to be measured by each measurement unit. Thus, work of changing the connection relation between charge/discharge units and a charge/discharge target, and correction work of obtaining the correction values require a huge amount of time. For this reason, when the conventional charge/discharge test system is used, the number of charge/discharge units to be electrically connected to the one charge/discharge target is fixed among charge/discharge test devices, that is, charge/discharge units to be used in a parallelly connected state are fixed.

For example, in a charge/discharge test system including four (four channels of) charge/discharge units with a maximum output current of 120 A, 2 channels of charge/discharge units are used electrically connected singly to charge/discharge targets different from each other, and the remaining 2 channels of charge/discharge units are used electrically connected to a same charge/discharge target. In this case, although the charge/discharge test system may execute a charge/discharge test with 120 A or less for each of the 4 channels under ordinary circumstances, since the charge/discharge units for the 2 channels of the 4 channels are connected in parallel, the charge/discharge test system is limited to a charge/discharge test for up to 3 channels. Since the number of parallel connections of charge/discharge units is fixed at two, although parallel connection of the four charge/discharge units allows a charge/discharge test with a current capacity of 480 A (120 A × 4 channels), the charge/discharge test system is limited to a charge/discharge test with a capacitive current of up to 240 A (120 A × 2 channels).

Thus, there is a need for a charge/discharge test system capable of easily changing the number of charge/discharge units electrically connected to a same charge/discharge target without requiring time for correction work.

The present invention has been made in view of the above-described circumstances, and has as its first object to provide a charge/discharge test system capable of easily changing the number of charge/discharge units electrically connected to a charge/discharge target.

Further, there is another problem in a case where charge/discharge units are electrically connected to one charge/discharge target to execute a charge/discharge test.

Specifically, a charge/discharge unit employing a switching control system that controls magnitude of output current by switching control that switches between switching elements, such as an FET (Field Effect Transistor), is often used in a charge/discharge test system. A current ripple (also called a ripple current) is output from a switching control-type charge/discharge unit.

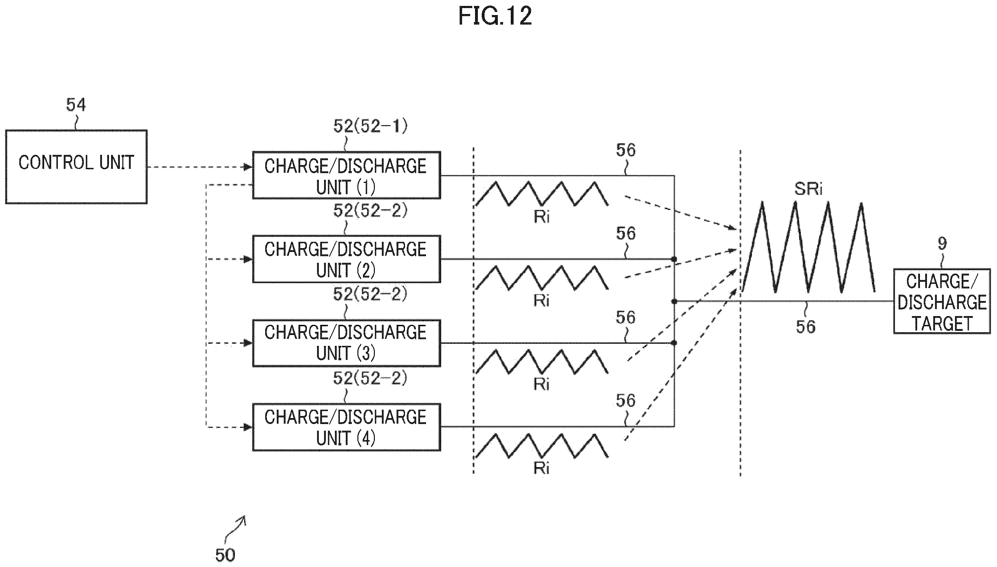

Thus, in a case where charge/discharge units are electrically connected in parallel to one charge/discharge target, a current ripple is produced for each of the charge/discharge units, and the current ripples are combined. In this case, a large combined current ripple (current noise) may be produced depending on phases (coincidence of peaks) of the current ripples (see Figure 12). Although the charge/discharge units operate independently, since internal switching frequencies thereof are the same, peaks of current ripples are highly likely to coincide. For this reason, when, for example, 4 channels of charge/discharge units are provided, a peak of a current ripple may be up to four times larger than that of a normal current ripple.

The present invention has been made in view of the above-described circumstances, and has as its second object to provide a charge/discharge test system capable of reducing current ripples.

For achieving the first object of the present invention, a charge/discharge test system includes: a plurality of charge/discharge units configured to perform charging and discharging of charge/discharge targets; a switching circuit capable of switching between combinations of electrical connection between one or more of the charge/discharge units and one or more of the charge/discharge targets; and a control unit configured to control the switching circuit to switch between the combinations.

According to the charge/discharge test system, it is possible to control the switching circuit so as to automatically execute switching between the combinations.

In the charge/discharge test system according to another aspect of the present invention, the switching circuit is capable of switching to a combination of electrical connection between one or more of the charge/discharge units and a same one of the charge/discharge targets. This eliminates the need for an operator to manually switch between the combinations.

The charge/discharge test system according to another aspect of the present invention includes: measurement units respectively provided for the charge/discharge units, and configured to measure at least any of voltages of the charge/discharge targets and currents flowing through the charge/discharge units; a correction value acquisition controlling unit configured to acquire, for each of the combinations, correction values for correcting measurement values by the measurement unit; and a correction unit configured to select correction values corresponding to a combination in the switching circuit from among the correction values for each of the combinations acquired by the correction value acquisition controlling unit, and correct the measurement value based on the selected correction values. This allows a significant reduction in the effort of correction work for acquiring respective correction values for the respective combinations.

In the charge/discharge test system according to another aspect of the present invention, one ends of the charge/discharge units are electrically connected to each other via a bus, and the other ends of the charge/discharge units are connected to the switching circuit, the control unit controls the charge/discharge units which are electrically connected to the charge/discharge targets via the switching circuit, to control charging and discharging of the charge/discharge targets, and the control unit charges power output from one or more of the charge/discharge targets to be discharged via the switching circuit and the charge/discharge unit, into chargeable one or more of the charge/discharge targets via the bus, the one or more of the charge/discharge units and the switching circuit. This allows enhancement of power utilization efficiency of the charge/discharge test system.

In the charge/discharge test system according to another aspect of the present invention, in a case where the charge/discharge targets connected to the other end of the switching circuit include: one or more test charge/discharge targets which are charge/discharge targets to be subjected to charge/discharge test; and one or more auxiliary charge/discharge targets which are charge/discharge targets other than the test charge/discharge targets, the control unit switches the switching circuit to a combination of electrical connection between charge/discharge units and a same one of the auxiliary charge/discharge targets. Thus, an increase in the number of connections of the charge/discharge units to be electrically connected to the same auxiliary charge/discharge target allows a significant increase in the amount of current to be charged into and discharged from the auxiliary charge/discharge target.

For achieving the second object of the present invention, a charge/discharge test system includes: a plurality of charge/discharge units configured to perform charging and discharging of a same charge/discharge target in a state where the plurality of charge/discharge units are connected in parallel to a same one charge/discharge target, the plurality of charge/discharge units configured to control magnitude of output current with a switching control system; and a control unit configured to make respective switching phases of the plurality of charge/discharge units different from each other.

According to the charge/discharge test system, respective current ripples output from the charge/discharge units cancel out each other. This allows a reduction in current ripples.

In the charge/discharge test system according to another aspect of the present invention, the control unit shifts the respective switching phases of the charge/discharge units by 360°/N from each other, wherein N (N is a natural number equal to or more than 2) represents a number of the charge/discharge units. This allows minimization of current ripples.

In the charge/discharge test system according to another aspect of the present invention, the plurality of charge/discharge units make the switching phases different from each other based on a synchronization signal input from the control unit.

The charge/discharge test system for achieving the first object of the present invention may reduce the effort of correction work in a case where a combination of electrical connection between one or more charge/discharge units and a charge/discharge target is changeable.

The charge/discharge test system for achieving the second object of the present invention may reduce current ripples.

### BRIEF DESCRIPTION OF THE DRAWINGS

Figure 1 is a schematic diagram of a charge/discharge test system according to a first embodiment;
Figure 2 is an explanatory diagram for explaining an example of electrical connection between one or more arbitrary charge/discharge test devices and one or more arbitrary charge/discharge targets by a switching circuit;
Figure 3 is an explanatory diagram for explaining an example of electrical connection between one or more arbitrary charge/discharge test devices and one or more arbitrary charge/discharge targets by the switching circuit;
Figure 4 is an explanatory chart showing combinations of one or more charge/discharge test devices electrically connectable to a same charge/discharge target;
Figure 5 is a flowchart showing a flow of correction work;
Figure 6 is an explanatory diagram for explaining a charge/discharge test on one or more charge/discharge targets by a charge/discharge test controlling unit and correction of a measurement value from a measurement unit by a correction unit;
Figure 7 is an explanatory diagram for explaining energy sharing (ES) using an auxiliary charge/discharge target by the charge/discharge test system;
Figure 8 is an explanatory diagram for explaining ES using the auxiliary charge/discharge target by the charge/discharge test system;
Figure 9 is a schematic diagram of a charge/discharge test system according to a second embodiment;
Figure 10 is a schematic diagram of a charge/discharge test system according to a third embodiment;
Figure 11 is a schematic diagram of a charge/discharge test system according to a fourth embodiment;
Figure 12 is an explanatory diagram for explaining a problem in execution of charging and discharging of a same charge/discharge target by charge/discharge test devices based on a switching control system;
Figure 13 is an explanatory diagram for explaining control of switching phases of charge/discharge test devices by a control unit; and
Figure 14 is a schematic diagram of a charge/discharge test system according to a fifth embodiment.

### DESCRIPTION OF THE EMBODIMENTS

### [First Embodiment]

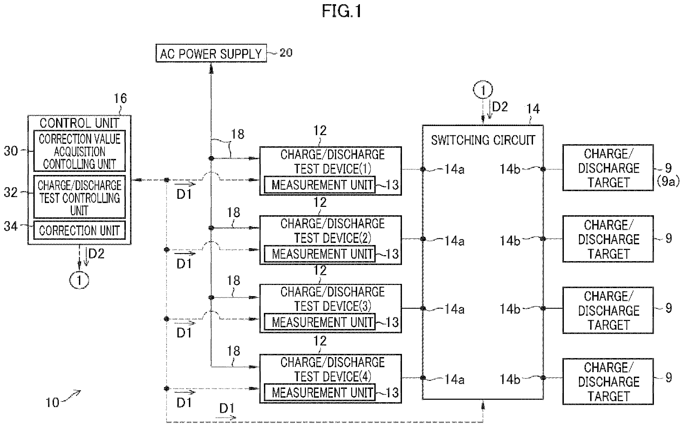

Figure 1 is a schematic diagram of a charge/discharge test system 10 according to a first embodiment. As shown in Figure 1, the charge/discharge test system 10 executes a charge/discharge test on one or more charge/discharge targets 9. Note that each charge/discharge target 9 is, for example, any one of various types of publicly known secondary batteries, such as a lithium ion battery, a nickel hydrogen battery, and an all-solid battery, (and devices including a large-capacity capacitor, such as an electric double layer capacitor, and capable of accumulating power).

The charge/discharge test system 10 includes: charge/discharge units, e.g., charge/discharge test devices 12; a switching circuit 14; and a control unit 16.

Four charge/discharge test devices 12 are provided, as indicated by the parenthesized numbers (1) to (4). The charge/discharge test devices 12 execute charging and discharging of the charge/discharge targets 9 electrically connected via the switching circuit 14 (to be described later) under control of the control unit 16 (to be described later). This allows the charge/discharge test system 10 to execute charge/discharge tests on up to four charge/discharge targets 9 in parallel. Note that the number of charge/discharge test devices 12 is not particularly limited as long as the number is two or more.

One ends of the charge/discharge test devices 12 are electrically connected to an AC power supply 20 via an AC bus 18. In other words, the charge/discharge test devices 12 are electrically connected to the AC power supply 20 via the AC bus 18. The other ends, which is on the opposite side from the one ends, of the charge/discharge test devices 12 are electrically connected to ports 14a different from each other of the switching circuit 14.

Although not shown, each charge/discharge test device 12 includes a bidirectional AC/DC converter and a bidirectional DC/DC converter. Each charge/discharge test device 12 executes AC/DC conversion that converts AC power (AC current) input from the AC power supply 20 via the AC bus 18 into DC power (DC current) and DC/DC conversion that lowers a high voltage of the DC power, and then outputs the voltage-lowered DC power to the charge/discharge target 9 via the switching circuit 14. The charge/discharge test device 12 also executes DC/DC conversion that increases a low voltage of DC power input from the charge/discharge target 9 via the switching circuit 14 and DC/AC conversion that converts the voltage-increased DC power into AC power, and then regeneratively returns the AC power to the AC power supply 20 or outputs the AC power to another charge/discharge test device 12, via the AC bus 18.

A measurement unit 13 is provided in each charge/discharge test device 12. Each measurement unit 13 measures at least either one of: a magnitude of a voltage of the charge/discharge target 9 electrically connected to the charge/discharge test device 12 via the switching circuit 14; and a magnitude of a current that flows through the charge/discharge test device 12 (both the magnitudes in the present embodiment) by a publicly known method, and outputs measurement values of voltage and current to the control unit 16. Note that the measurement units 13 may be provided separately from the charge/discharge test devices 12.

Here, a description is given in the present embodiment, taking as an example a case where each charge/discharge test device 12 includes a bidirectional AC/DC converter and a bidirectional DC/DC converter (both not shown). However, each charge/discharge test device 12 may include only a bidirectional DC/DC converter as a converter. In this case, the bidirectional AC/DC converter is electrically connected to the AC power supply 20 via the AC bus 18, and the charge/discharge test devices 12 are electrically connected in parallel to the bidirectional AC/DC converter via a DC bus (not shown).

The switching circuit 14 has ports 14a are on one end side thereof, and ports 14b on the other end side, which is on the opposite side from the one end of the switching circuit 14. Respective charge/discharge test devices 12 may be electrically connected to the ports 14a. Respective charge/discharge targets 9 may be electrically connected to the ports 14b. Thus, in the switching circuit 14, the charge/discharge test devices 12 are electrically connected to the respective ports 14a, and the charge/discharge targets 9 are electrically connected to the respective ports 14b.

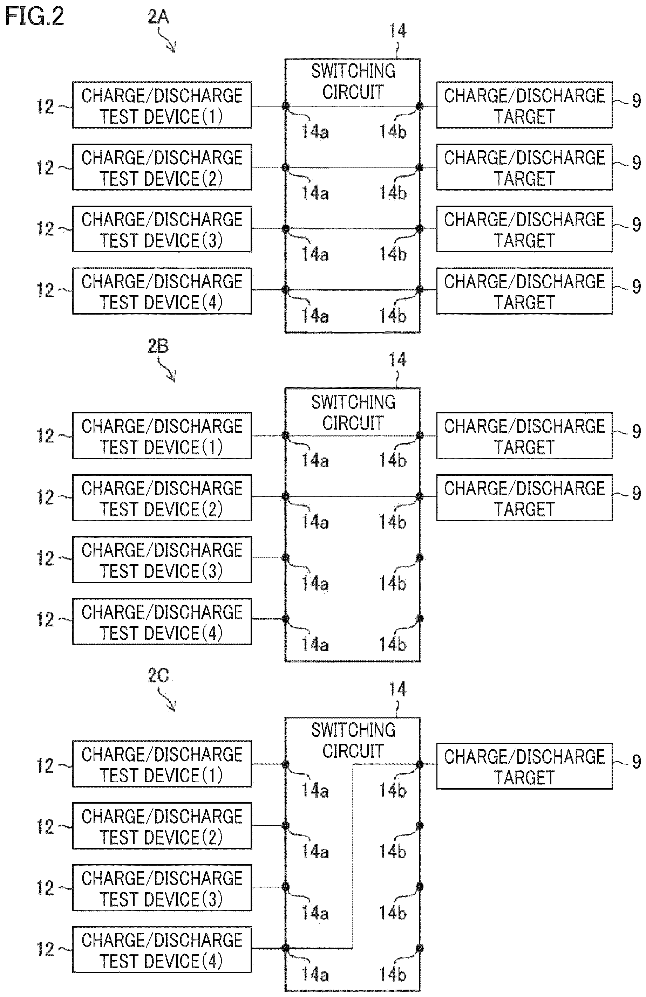

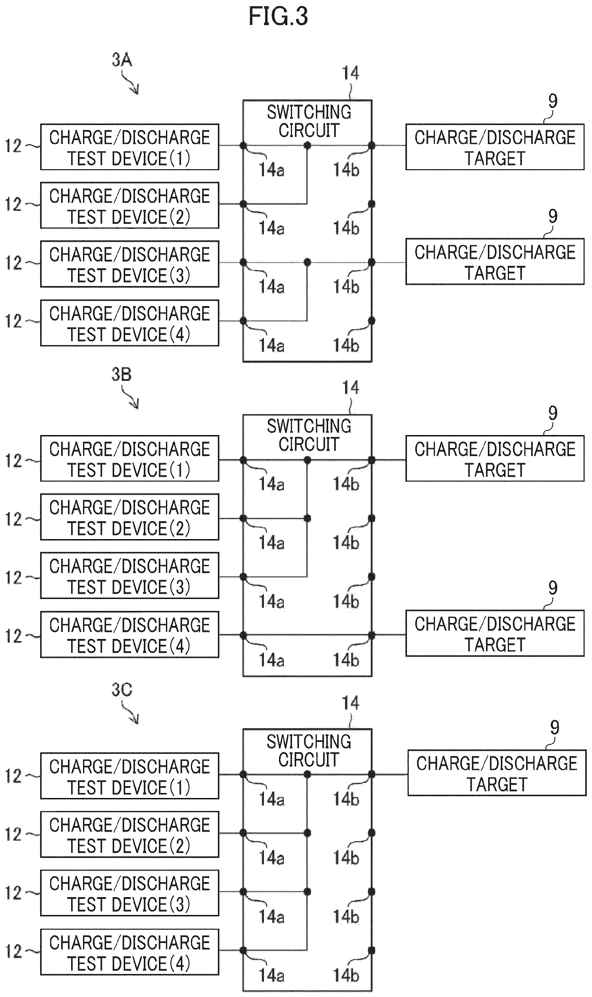

Figures 2 and 3 are explanatory diagrams for explaining examples of electrical connection between one or more arbitrary charge/discharge test devices 12 and one or more arbitrary charge/discharge targets 9 by the switching circuit 14. The switching circuit 14 can electrically connect the plurality of ports 14a and the plurality of ports 14b in an arbitrary manner under control of the control unit 16 (to be described later). For example, as indicated by reference characters 2A to 2C in Figure 2, the switching circuit 14 may electrically connect the ports 14a and the ports 14b on a one-to-one basis. As indicated by reference characters 3A to 3C in Figure 3, the switching circuit 14 may electrically connect a plurality of ports 14a and an arbitrary port 14b on a many-to-one basis. In a case where a plurality of ports 14a and an arbitrary port 14b are electrically connected on a many-to-one basis, the respective charge/discharge test devices 12 that are connected to the plurality of ports 14a connected to the arbitrary port 14b are electrically connected in parallel. As described above, the switching circuit 14 may electrically connect one or more charge/discharge targets 9 and one or more charge/discharge test devices 12 in an arbitrary manner.

The switching circuit 14 is capable of switching a combination of at least one charge/discharge test device 12 to be electrically connected to the charge/discharge target 9 (hereinafter also simply referred to as a combination of the charge/discharge test devices 12 or a device combination). The switching circuit 14 may switch, for example, the number (hereinafter simply referred to as the number of connections or the number of parallels) of parallel-connected charge/discharge test devices 12 which are parallelly connected to one charge/discharge target 9. In other words, the switching circuit 14 can arbitrarily increase or decrease the number of parallels of the charge/discharge test devices 12 to be electrically connected to one charge/discharge target 9 (see Figure 3). That is, the charge/discharge test system 10 may change a current capacity with which the charge/discharge target 9 may be charged and discharged, by changing the number of parallels by the switching circuit 14.

As described earlier, in a case where the switching circuit 14 is controlled to switch a combination of the charge/discharge test devices 12 for the charge/discharge target 9, especially switch the number of parallels of the charge/discharge test devices 12, correction values are required in order to correct voltage and current measurement values measured by the measurement unit 13 of each charge/discharge test device 12. Correction work (hereinafter simply referred to as "correction work") of obtaining correction values for each of combinations of the charge/discharge test devices 12 is executed in advance by, for example, a manufacturer of the charge/discharge test system 10. Note that correction work is also called calibration work.

Referring back to Figure 1, for example, a publicly known control device, such as a programmable logic controller (PLC), is used as the control unit 16. A combination of the PLC and a PC (Personal Computer) or a terminal (e.g., a mobile terminal or a tablet terminal) other than a PC may be used as the control unit 16.

The control unit 16 is electrically connected to the charge/discharge test devices 12 and the switching circuit 14. At the time of a charge/discharge test, the control unit 16 controls one or more charge/discharge test devices 12 and the switching circuit 14 in accordance with a charge/discharge pattern for the charge/discharge target 9 input in advance by an operator to execute a charge/discharge test on one or more charge/discharge targets 9. At the time of correction work, the control unit 16 controls the charge/discharge test devices 12 and the switching circuit 14 to acquire correction values for each combination of the charge/discharge test devices 12.

The control unit 16 includes a correction value acquisition controlling unit 30, a charge/discharge test controlling unit 32, and a correction unit 34. The units may be implemented through, for example, execution of a control program (not shown) by the control unit 16 or may be circuits for executing functions.

The correction value acquisition controlling unit 30 controls correction work. Note that the correction value acquisition controlling unit 30 executes correction work in, for example, a state where a charge/discharge target 9a (including a voltage and current generator that is chargeable and dischargeable) for correction work is electrically connected to one arbitrary port 14b of the switching circuit 14. Assume that respective charge/discharge test devices 12 are electrically connected to four ports 14a of the switching circuit 14, i.e., four charge/discharge test devices 12 are electrically connected to the switching circuit 14 in correction work of the present embodiment.

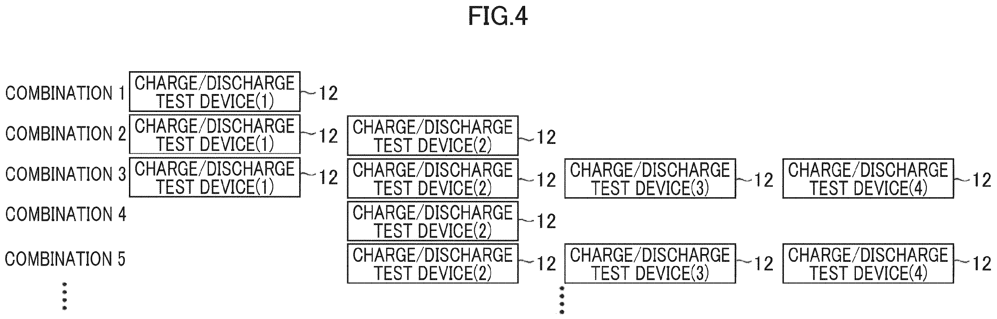

Figure 4 is an explanatory chart showing combinations (device combinations) of one or more charge/discharge test devices 12 electrically connectable to the same charge/discharge target 9a. As shown in Figure 4 and Figure 1, the number of patterns for a device device combination is determined depending on the number of charge/discharge test devices 12 mounted on the charge/discharge test system 10. Since the number of charge/discharge test devices 12 is four in the present embodiment, the number of patterns for a combination of the charge/discharge test devices 12 is ten. The correction value acquisition controlling unit 30 sequentially executes device combination switching for all combinations.

Specifically, the correction value acquisition controlling unit 30 repeatedly executes, for all the device combinations, a process of generating a combination command signal D1 indicating a device combination and a process of outputting the combination command signal D1 to the switching circuit 14 and the corresponding charge/discharge test device(s) 12. Note that, in electrically connecting a plurality of charge/discharge test devices 12 in parallel to the charge/discharge target 9a by the switching circuit 14, a combination command signal D1 includes a parallel command signal (e.g., a synchronization signal) for simultaneously executing charging and discharging of the same charge/discharge target 9a by the plurality of charge/discharge test devices 12.

The switching circuit 14 executes switching to a device combination designated by a combination command signal D1 input from the correction value acquisition controlling unit 30. All of the charge/discharge test devices 12, to which the combination command signal D1 is input from the correction value acquisition controlling unit 30, execute charging and discharging of the charge/discharge target 9a in accordance with a predetermined charge/discharge pattern for correction value calculation. In this manner, switching in the switching circuit 14 corresponding to a device combination and charging and discharging of the charge/discharge target 9a by all charge/discharge test devices 12 corresponding to the device combination, are repeatedly executed.

The correction value acquisition controlling unit 30 repeatedly executes, for each of all combinations, a process of outputting a correction condition switching command signal D2 corresponding to the device combination to the switching circuit 14. A correction condition switching command signal D2 is a control signal for switching to a correction condition (e.g., short-circuit of an output circuit at the time of offset adjustment and polarity switching at the time of voltage correction) corresponding to a device combination and is defined for each device combination. The switching circuit 14 operates in accordance with a correction condition switching command signal D2 input from the correction value acquisition controlling unit 30. In this manner, correction condition switching for the switching circuit 14 corresponding to a device combination is repeatedly executed.

Additionally, each time charging and discharging of the charge/discharge target 9a is executed by the charge/discharge test devices 12 corresponding to a device combination, the correction value acquisition controlling unit 30 repeatedly executes: acquisition of voltage and current measurement values from the measurement units 13 of the charge/discharge test devices 12 that execute the charging and discharging; and correction value calculation based on the acquired measurement values. Note that, since a specific method for calculating a correction value is a publicly known technique, a specific description thereof will be omitted. Thus, correction values for the measurement units 13 for each device combination are obtained and are stored in, e.g., a storage unit (not shown).

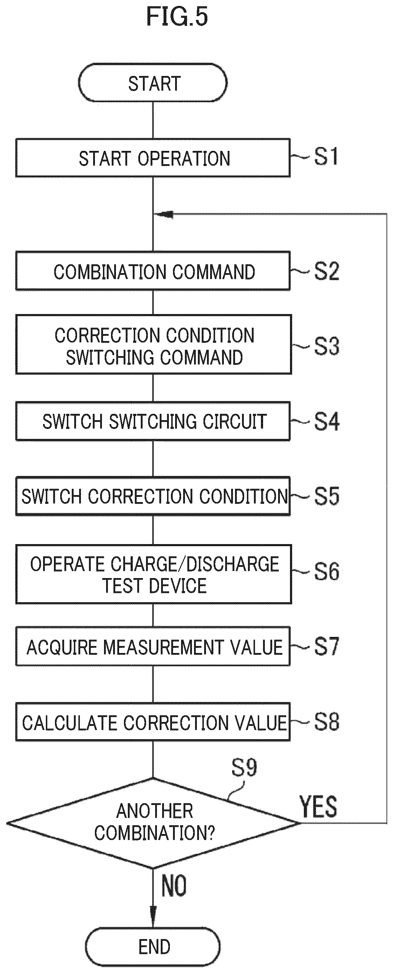

Figure 5 is a flowchart showing a flow of correction work. As shown in Figure 5, in the manufacturer of the charge/discharge test system 10, after the charge/discharge target 9a is connected to one arbitrary port 14b of the switching circuit 14, an operation part (not shown) is operated to input a starting operation for correction work to the control unit 16 (step S1).

When the starting operation for correction work is input, the control unit 16 functions as the correction value acquisition controlling unit 30. The correction value acquisition controlling unit 30 executes: a process of generating a combination command signal D1 indicating a first device combination of all device combinations; and a process of outputting the combination command signal D1 to the switching circuit 14 and the corresponding charge/discharge test devices 12 (step S2). The correction value acquisition controlling unit 30 also executes a process of outputting a correction condition switching command signal D2 corresponding to the first device combination to the switching circuit 14 (step S3). Note that step S2 and step S3 may be executed in reverse order or may be executed at the same time.

The switching circuit 14 switches device combination to the first device combination on the basis of the combination command signal D1 input from the correction value acquisition controlling unit 30 (step S4). The switching circuit 14 switches correction condition for the switching circuit 14 corresponding to the first device combination in accordance with the correction condition switching command signal D2 input from the correction value acquisition controlling unit 30 (step S5).

When switching in the switching circuit 14 and switching of correction condition are completed, all of the charge/discharge test devices 12 corresponding to the first device combination operate to execute charging and discharging of the charge/discharge target 9a in accordance with the predetermined charge/discharge pattern for correction value calculation (step S6).

While charging and discharging of the charge/discharge target 9a by the charge/discharge test devices 12 corresponding to the first device combination is executed, the correction value acquisition controlling unit 30 acquires measurement values of voltage and current (voltage and current measurement values) from the measurement units 13 of the charge/discharge test devices 12 executing the charging and discharging (step S7). The correction value acquisition controlling unit 30 calculates correction values on the basis of the acquired voltage and current measurement values (step S8). Thus, acquisition of the correction values corresponding to the first device combination is completed, and the correction values are stored in the storage unit (not shown) by the correction value acquisition controlling unit 30.

The processes in step S2 to step S8 are repeatedly executed for all of second and subsequent device combinations, and acquisition and storage of correction values corresponding to all the device combinations are completed (step S9). At the time of the repeated execution, switching in the switching circuit 14 and correction condition switching may be automatically executed. This eliminates the need for an operator to manually perform switching and largely reduces the effort of correction work. As a result, it is unnecessary to use the charge/discharge test devices 12 in a state where some of the charge/discharge test devices 12 is dedicated to be electrically connected singly to a charge/discharge target 9 and the others are dedicated to be electrically connected in parallel to a charge/discharge target 9, unlike conventional art. Since the number of connections of the charge/discharge test devices 12 may be arbitrarily increased or decreased depending on a capacity and the like of the charge/discharge target 9 which is an object of charge/discharge test, an amount of current that may be charged into and discharged from the charge/discharge target 9 may be freely changed.

Note that correction values corresponding to all device combinations are acquired in the first embodiment. However, when the types of the charge/discharge test devices 12 are the same, correction values may be acquired while changing only the number of connections of the charge/discharge test devices 12. For example, because the number of connections of the charge/discharge test devices 12 may range from 1 to 4 in the first embodiment, and four types of sets of correction values are obtained.

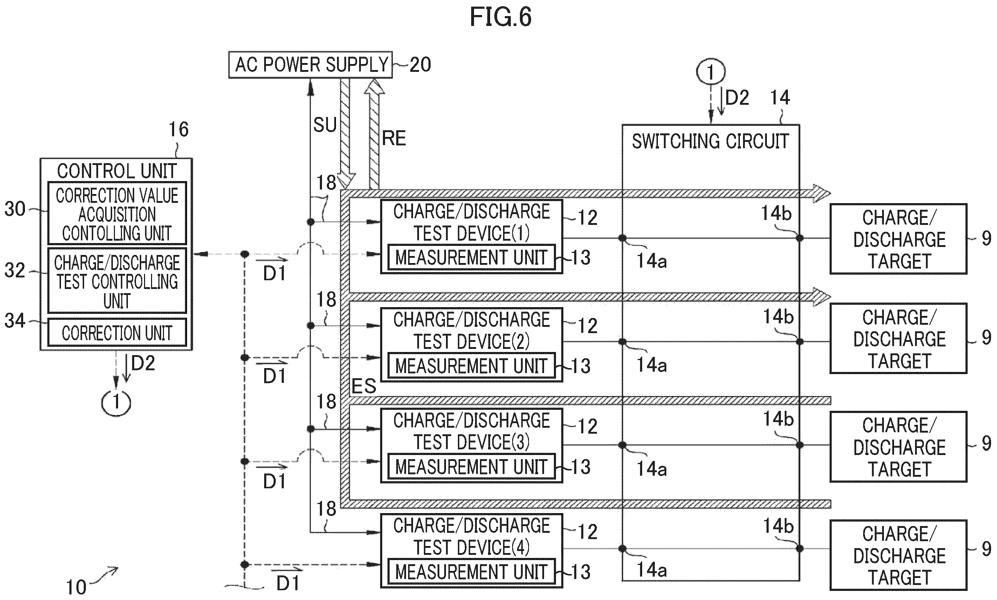

Figure 6 is an explanatory diagram for explaining a charge/discharge test on one or more charge/discharge targets 9 by the charge/discharge test controlling unit 32 and correction of measurement values from the measurement unit 13 by the correction unit 34.

As shown in Figure 6, the charge/discharge test controlling unit 32 executes switching in the switching circuit 14 on the basis of a combination of one or more charge/discharge test devices 12 and one or more charge/discharge targets 9 at the time of a charge/discharge test that is input by the operator. The charge/discharge test controlling unit 32 controls the one or more charge/discharge test devices 12 to control charging and discharging of the one or more charge/discharge targets 9 on the basis of a charge/discharge pattern for a charge/discharge test for the charge/discharge target 9 that is input in advance by the operator.

In executing charge/discharge control of a plurality of charge/discharge targets 9, the charge/discharge test controlling unit 32 synchronizes a charge timing to execute charging of one or more charge/discharge targets 9 of the plurality of charge/discharge targets 9, with a discharge timing to execute discharging of one or more different charge/discharge targets 9. Thus, the charge/discharge test controlling unit 32 executes energy sharing (ES) that uses power discharged from the one or more charge/discharge targets 9 to charge the one or more different charge/discharge targets 9.

The charge/discharge test controlling unit 32 also determines whether there is a surplus or a shortage of discharge power that is power discharged from all of the charge/discharge targets 9 to be discharged, with respect to necessary charge power that is power necessary to charge all of the charge/discharge targets 9 to be charged. In a case where there is a surplus of the discharge power (the discharge power is in surplus) over the necessary charge power, the charge/discharge test controlling unit 32 regeneratively returns surplus power by an amount corresponding to an amount (surplus amount) of the surplus of the discharge power from one or more charge/discharge targets 9 to the AC power supply 20 via the switching circuit 14, one or more charge/discharge test devices 12, and the AC bus 18, in addition to execution of the ES described above (see reference character RE).

On the other hand, in a case where there is a shortage of the discharge power (the discharge power is in short) below the necessary charge power, the charge/discharge test controlling unit 32 charges shortage power by an amount corresponding to an amount (shortage amount) of the shortage of the discharge power from the AC power supply 20 to one or more charge/discharge targets 9 via the AC bus 18, one or more charge/discharge test devices 12, and the switching circuit 14, in addition to execution of the ES (see reference character SU).

In a case where a charge/discharge test is executed on one or more charge/discharge targets 9 by the charge/discharge test controlling unit 32, the correction unit 34 selects and acquires, from the storage unit (not shown), correction values corresponding to a combination of one or more charge/discharge test devices 12 and the one or more charge/discharge targets 9 that are electrically connected via the switching circuit 14. The correction unit 34 corrects voltage and current measurement values measured by the measurement units 13 of all of the charge/discharge test devices 12 under execution of the charge/discharge test on the basis of the acquired correction values. Note that the corrected measurement values are used for charge/discharge control by the charge/discharge test controlling unit 32.

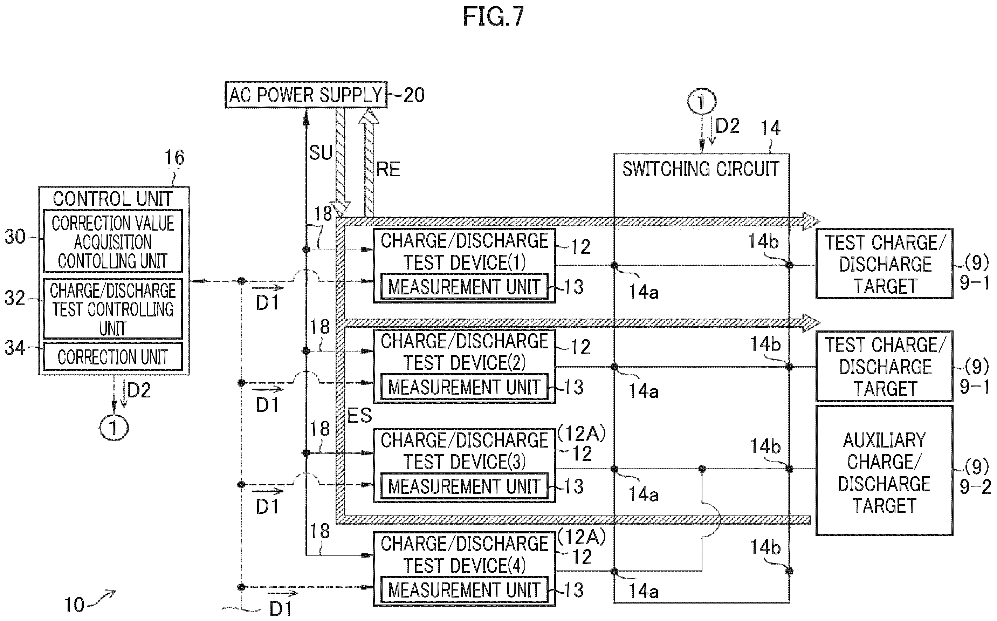

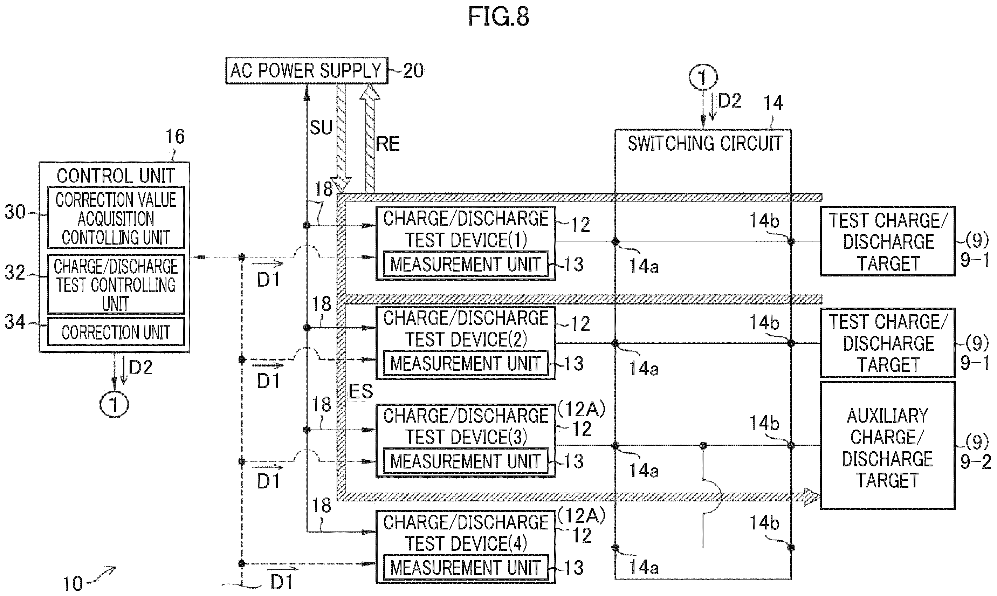

Figures 7 and 8 are explanatory diagrams for explaining ES using an auxiliary charge/discharge target 9-2 by the charge/discharge test system 10. As shown in Figures 7 and 8, the charge/discharge targets 9 include: one or more test charge/discharge targets 9-1 which are charge/discharge targets 9 to be subjected to charge/discharge test (charge/discharge targets 9 being objects of charge/discharge test); and one or more auxiliary charge/discharge targets 9-2 which are charge/discharge targets 9 not to be subjected to the charge/discharge test. One or more test charge/discharge targets 9-1 and one or more auxiliary charge/discharge targets 9-2 may be electrically connected to the switching circuit 14. Note that although one auxiliary charge/discharge target 9-2 is electrically connected to the switching circuit 14 in Figures 7 and 8, a plurality of auxiliary charge/discharge targets 9-2 may be electrically connected.

The test charge/discharge target 9-1 and the auxiliary charge/discharge target 9-2 are different from each other in that whether or not they are to be subjected to test charge/discharge test. However, types of both the test charge/discharge target 9-1 and the auxiliary charge/discharge target 9-2 may be the same or not the same, for example. Hereinafter, the charge/discharge test device 12 that is electrically connected to the auxiliary charge/discharge target 9-2 via the switching circuit 14 will be referred to as a "surplus unit 12A" as appropriate.

The charge/discharge test controlling unit 32 compares the necessary charge power necessary to charge all the test charge/discharge targets 9-1 to be charged in a charge/discharge test, with the discharge power that is power discharged from all the test charge/discharge targets 9-1 to be discharged. In a case where there is a surplus of the discharge power over the necessary charge power, the charge/discharge test controlling unit 32 executes charging of surplus power into the auxiliary charge/discharge targets 9-2, in addition to execution of the ES described earlier.

Specifically, the charge/discharge test controlling unit 32 controls one or more charge/discharge test devices 12 and one or more surplus units 12A to execute charging of surplus power into one or more auxiliary charge/discharge targets 9-2. Thus, the surplus power output from the one or more test charge/discharge targets 9-1 via the switching circuit 14 and the charge/discharge test devices 12 is charged into the one or more auxiliary charge/discharge targets 9-2 via the AC bus 18, the one or more charge/discharge test devices 12, and the switching circuit 14 (see Figure 8).

Here, in a case where the surplus power exceeds a chargeable capacity of all the auxiliary charge/discharge targets 9-2, excess power is regeneratively returned to the AC power supply 20 by an amount corresponding to an amount (excess amount) of the excess (see reference character RE).

On the other hand, in a case where there is a shortage of the discharge power below the necessary charge power, the charge/discharge test controlling unit 32 executes discharging of power from the auxiliary charge/discharge targets 9-2, in addition to execution of the ES. Specifically, the charge/discharge test controlling unit 32 controls one or more charge/discharge test devices 12 and one or more surplus units 12A to execute power supply from the one or more auxiliary charge/discharge targets 9-2. Thus, power output from the one or more auxiliary charge/discharge targets 9-2 via the switching circuit 14 and the surplus units 12A is charged into the one or more test charge/discharge targets 9-1 via the AC bus 18, the one or more charge/discharge test devices 12, and the switching circuit 14 (see Figure 7).

Note that, in a case where the shortage amount of the discharge power below the necessary charge power cannot be covered (supplemented) only by power discharged from all the auxiliary charge/discharge targets 9-2, the shortage is further covered (supplemented) by power supply from the AC power supply 20 (see reference character SU).

Accordingly, charging of the surplus power into the auxiliary charge/discharge target 9-2 or power supply from the auxiliary charge/discharge target 9-2 minimizes surplus power to be regeneratively returned to the AC power supply 20 and power to be supplied from the AC power supply 20. This improves power utilization efficiency of the charge/discharge test system 10.

As described earlier, the number of connections of the charge/discharge test devices 12 to be electrically connected to the same (one) charge/discharge target 9 (the test charge/discharge target 9-1 or the auxiliary charge/discharge target 9-2) via the switching circuit 14 may be arbitrarily increased or decreased in the charge/discharge test system 10 according to the first embodiment. For this reason, an increase in the number of connections of the charge/discharge test devices 12 allows a significant increase in the amount of current to be charged into and discharged from the auxiliary charge/discharge target 9-2. This reduces the surplus power to be regeneratively returned to the AC power supply 20 and the power supply from the AC power supply 20, which further improves the power utilization efficiency of the charge/discharge test system 10. Since a plurality of surplus units 12A may be parallelly controlled in accordance with a same charge/discharge pattern, simplification of control and a reduction in load may be achieved as compared with a case where the surplus units 12A are controlled independently in accordance with charge/discharge pattern different from each other.

In addition, it is possible to release parallel connection between the surplus units 12A and the same auxiliary charge/discharge target 9-2, to increase the number of auxiliary charge/discharge targets 9-2 (number of channels) to be electrically connected to the switching circuit 14 at a user's desire.

As has been described above, the switching circuit 14 that may arbitrarily switch electrical connection between one or more charge/discharge test devices 12 and one or more charge/discharge targets 9 and 9a is provided to the charge/discharge test system 10 according to the first embodiment. This makes it possible to change a combination of one or more charge/discharge test devices 12 which is to be electrically connected to the charge/discharge target 9 or 9a, as well as significantly reducing the effort of correction work.

### [Second Embodiment]

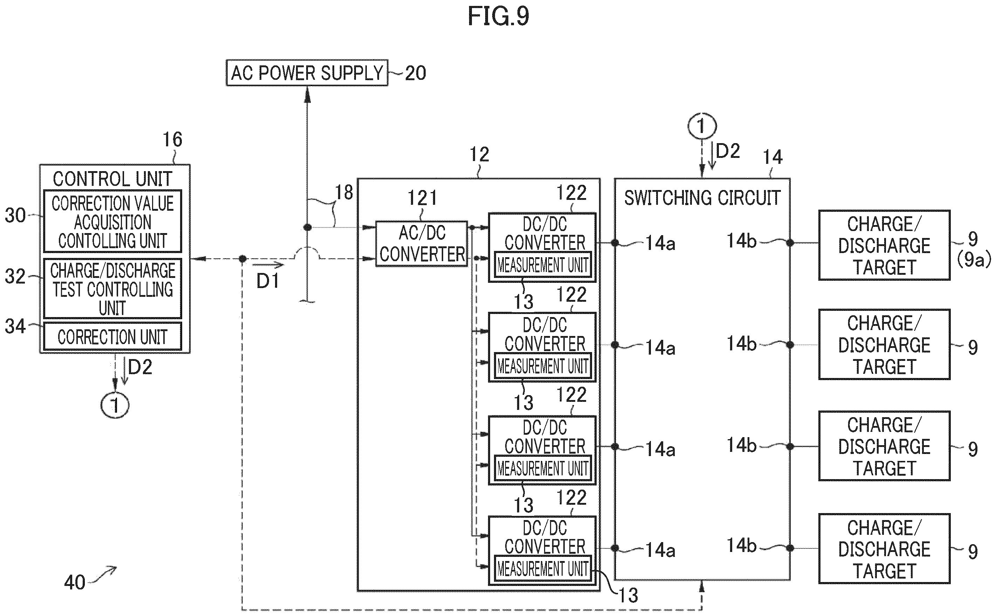

Figure 9 is a schematic diagram of a charge/discharge test system 40 according to a second embodiment. As shown in Figure 9, the charge/discharge test system 40 executes a charge/discharge test on one or more charge/discharge targets 9.

The charge/discharge test system 40 includes a charge/discharge test device 12, a switching circuit 14, and a control unit 16.

The charge/discharge test device 12 has a bidirectional AC/DC converter 121 and a plurality of charge/discharge units, e.g., bidirectional DC/DC converters 122. Note that, in Figure 9, a bidirectional AC/DC converter is simply referred to as an AC/DC converter, and a bidirectional DC/DC converter is simply referred to as a DC/DC converter.

The bidirectional DC/DC converters 122 are connected to charge/discharge targets 9 via the switching circuit 14, like the charge/discharge test devices 12 in the first embodiment.

The switching circuit 14 is capable of switching a combination of at least one bidirectional DC/DC converter 122 to be electrically connected to the charge/discharge target 9 (hereinafter also simply referred to as a combination of the converters 122 or a converter combination), as in the case of the charge/discharge test devices 12 in the first embodiment. The switching circuit 14 may switch, for example, the number of parallel-connected bidirectional DC/DC converters 122 to be electrically connected to one charge/discharge target 9 (the number of connections or the number of parallels). In a case where the switching circuit 14 is controlled to switch a converter combination for the charge/discharge target 9, especially switch the number of parallels of the bidirectional DC/DC converters 122, the switching circuit 14 corrects voltage and current measurement values measured by measurement units 13 of the bidirectional DC/DC converters 122 with correction values (converter combination-specific correction values) for each converter combination, as in the first embodiment.

### [Third Embodiment]

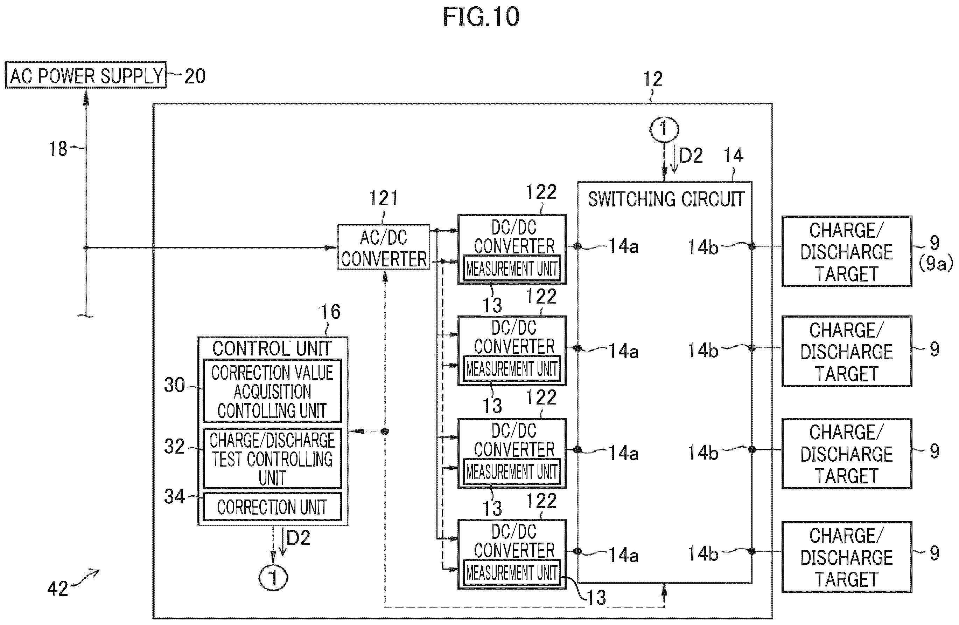

Figure 10 is a schematic diagram of a charge/discharge test system 42 according to a third embodiment. As shown in Figure 10, the charge/discharge test system 42 executes a charge/discharge test on one or more charge/discharge targets 9.

A charge/discharge test device 12 includes a bidirectional AC/DC converter 121, a plurality of charge/discharge units, e.g., bidirectional DC/DC converters 122, a switching circuit 14, and a control unit 16. Note that, in Figure 10, a bidirectional AC/DC converter is simply referred to as an AC/DC converter, and a bidirectional DC/DC converter is simply referred to as a DC/DC converter.

The bidirectional DC/DC converters 122 are connected to charge/discharge targets 9 via the switching circuit 14, like the charge/discharge test devices 12 in the first embodiment.

The switching circuit 14 may switch the number of parallels of the bidirectional DC/DC converters 122 to be electrically connected to one charge/discharge target 9, as in the second embodiment.

### [Fourth Embodiment]

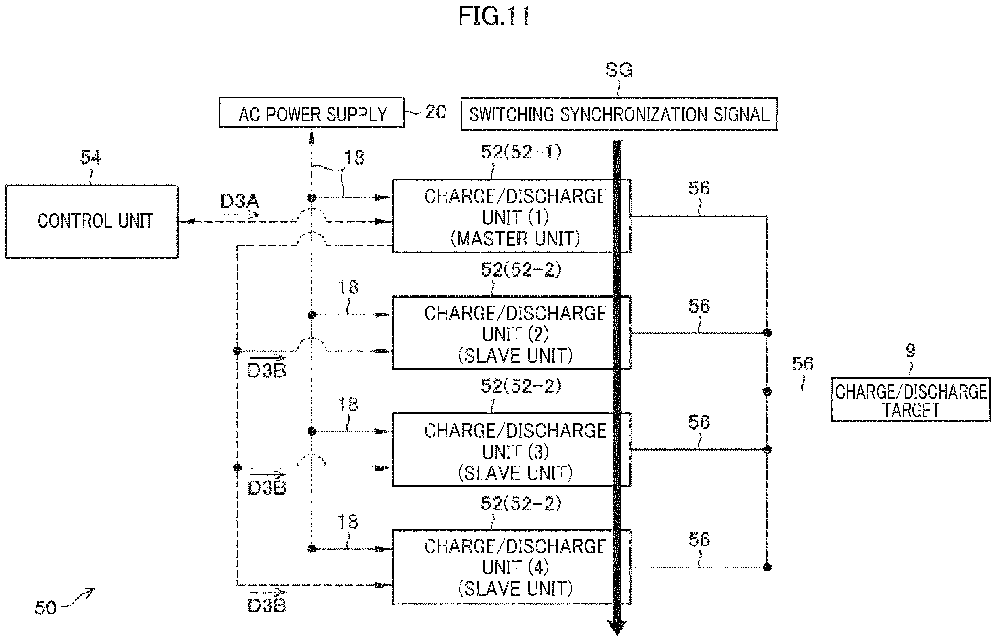

Figure 11 is a schematic diagram of a charge/discharge test system 50 according to a fourth embodiment. As shown in Figure 11, the charge/discharge test system 50 uses a plurality of charge/discharge unit 52 to execute a charge/discharge test on one charge/discharge target 9. Note that the charge/discharge target 9 in the fourth embodiment is the same as the charge/discharge target 9 described in the first embodiment.

The charge/discharge test system 50 according to the fourth embodiment includes the plurality of charge/discharge units 52 and a control unit 54. The charge/discharge unit 52 may be, for example, a charge/discharge test device or a bidirectional DC/DC converter. Note that, in a case where the charge/discharge unit 52 is a bidirectional DC/DC converter, a bidirectional AC/DC converter (not shown) is arranged between an AC power supply and the bidirectional DC/DC converter, as shown in Figure 9 or 10.

Four charge/discharge units 52 are provided in the same manner as in the first embodiment, as indicated by the parenthesized numbers (1) to (4). The charge/discharge units 52 execute charging and discharging of the same charge/discharge target 9 under control of the control unit 54 (to be described later). Note that the number of charge/discharge units 52 is not particularly limited as long as the number is two or more.

One ends of the charge/discharge units 52 are electrically connected to an AC power supply 20 via an AC bus 18, as in the first embodiment. In other words, the plurality of parallel-connected charge/discharge units 52 are electrically connected to the AC power supply 20 via the AC bus 18. The other ends, which is on the opposite side from the one ends, of the charge/discharge units 52 are electrically connected to the same charge/discharge target 9 via a DC bus 56. In other words, the plurality of parallel-connected charge/discharge units 52 are electrically connected to the same charge/discharge target 9 via the DC bus 56.

Each charge/discharge unit 52 is basically the same in configuration as the charge/discharge test device 12 according to the first embodiment. The charge/discharge unit 52 executes: AC/DC conversion to convert AC power input from the AC power supply 20 via the AC bus 18 into DC power; and DC/DC conversion to decrease a high voltage of the DC power. Then, the charge/discharge unit 52 outputs the DC power with decreased voltage, to the charge/discharge target 9 via the DC bus 56. Each charge/discharge unit 52 also executes: DC/DC conversion to increase a low voltage of DC power input from the charge/discharge target 9 via the DC bus 56; and DC/AC conversion to convert the DC power with increased voltage into AC power. Then, each charge/discharge unit 52 regeneratively returns the AC power to the AC power supply 20 via the AC bus 18.

Note that each charge/discharge unit 52 may execute only DC/DC conversion. In this case, the charge/discharge units 52 are electrically connected in parallel via a DC bus (not shown) to a bidirectional AC/DC converter electrically connected to the AC power supply 20 via the AC bus 18.

Any one of the charge/discharge units 52 is a master unit 52-1 (also called a master converter), and the remaining one(s) of the charge/discharge units 52 is (are each) a slave unit 52-2 (also called a slave converter). The master unit 52-1 executes charging and discharging of the charge/discharge target 9 in accordance with a charge/discharge command D3A input from the control unit 54, and outputs a parallel signal D3B including an I/O (Input/Output) signal and a current reference signal (analog signal) to each slave unit 52-2 . Each slave unit 52-2 executes charging and discharging of the charge/discharge target 9 on the basis of the parallel signal D3B input from the master unit 52-1. For example, the master unit 52-1 outputs a command to output a current of 120 A to itself and outputs a parallel signal D3B to execute output of a current of 120 A to the three remaining slave units 52-2 in order to output a DC current of 480 A to the charge/discharge target 9.

Note that all the charge/discharge units 52 may execute charging and discharging of the charge/discharge target 9 in accordance with a charge/discharge command D3A directly input from the control unit 54, without grouping the charge/discharge units 52 into the master unit 52-1 and a plurality of slave units 52-2. The charge/discharge test devices 12 according to the first embodiment, the DC/DC converters 122 according to the second embodiment, and the DC/DC converters 122 according to the third embodiment may each be grouped into a master and slaves, as in the present embodiment.

Although not shown in drawings, each charge/discharge unit 52 employs a switching control system (switching control method) that controls the magnitude of output current by switching control that switches between switching elements, such as an FET.

A PLC or a combination of a PLC and a PC or a terminal other than a PC is used as the control unit 54, as with the control units 16 according to the first to third embodiments. The control unit 54 is electrically connected to the master unit 52-1.

The control unit 54 outputs a charge/discharge command D3A to the master unit 52-1 in accordance with a charge/discharge pattern (including the amount of current to be charged into and discharged from the charge/discharge target 9) for the charge/discharge target 9 that is input in advance by an operator at the time of a charge/discharge test on the charge/discharge target 9. Thus, the master unit 52-1 executes charging and discharging of the charge/discharge target 9 in accordance with the charge/discharge command D3A, and each slave unit 52-2 executes charging and discharging of the charge/discharge target 9 on the basis of a parallel signal D3B input from the master unit 52-1. That is, the four charge/discharge units 52 (the master unit 52-1 and the slave units 52-2) may simultaneously charge and discharge the same charge/discharge target 9. For example, in a case where a maximum output current for each charge/discharge unit 52 is 120 A, a current of 480 A (= 120 A × 4) may be charged into and discharged from the same (one) charge/discharge target 9 by the charge/discharge units 52.

The control unit 54 also outputs a switching synchronization signal SG that controls a switching phase of each charge/discharge unit 52 (a switching element of the charge/discharge unit 52) of the switching control method-type, to the charge/discharge unit 52. Specifically, the control unit 54 outputs the switching synchronization signal SG to the master unit 52-1, and the switching synchronization signal SG is output to the slave units 52-2 via the master unit 52-1. Thus, the switching phases of the charge/discharge units 52 may be synchronized or desynchronized on the basis of the switching synchronization signal SG spanning the charge/discharge units 52.

Figure 12 is an explanatory diagram for explaining a problem in execution of charging and discharging of the same (one) charge/discharge target 9 by the charge/discharge test units 52 based on the switching control system. Note that, for brevity of illustration, the AC bus 18 and the AC power supply 20 are not shown in Figure 12.

In a case where the switching phases of the charge/discharge units 52 are synchronized, phases of respective current ripples Ri output from the charge/discharge units 52 are likely to match each other. As a result, when the current ripples Ri output from the charge/discharge units 52 are combined, a combined current ripple SRi (current noise) having a magnitude of a peak up to four times larger than the the current ripples Ri, may be produced depending on coincidence (overlapping) of peaks of the current ripples Ri.

For this reason, the control unit 54 controls the switching phases of the charge/discharge units 52 so as to reduce the combined current ripple SRi.

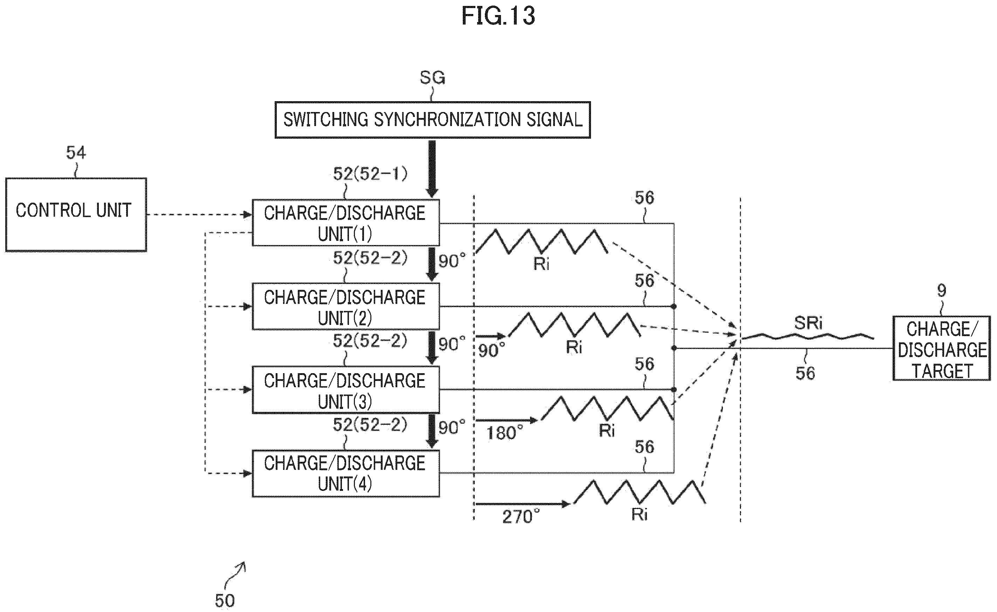

Figure 13 is an explanatory diagram for explaining control of the switching phases of the charge/discharge units 52 by the control unit 54. As shown in Figure 13, the control unit 54 makes the switching phases of the charge/discharge units 52 different from each other on the basis of a switching synchronization signal SG.

Specifically, letting N (N is a natural number equal to or more than 2) be the number of charge/discharge units 52 electrically connected in parallel to the same charge/discharge target 9 via the DC bus 56, the control unit 54 shifts the switching phases of the charge/discharge units 52 by 360°/N from each other. Since N = 4 here, the control unit 54 shifts the switching phases of the charge/discharge units 52 by 90° from each other. This makes it possible to shift the phases of the current ripples Ri output from the charge/discharge units 52 by 90° from each other. For example, the phases of the current ripples Ri output from the charge/discharge units 52 (the slave units 52-2) indicated by the parenthesized numbers (2) to (4) are shifted by 90°, 180°, and 270°, respectively, from the phase of the current ripple Ri output from the charge/discharge unit 52 (the master unit 52-1) indicated by the parenthesized number (1).

As described above, the phases of the current ripples Ri output from the charge/discharge units 52 are shifted from each other, and positions of peaks of the current ripples Ri are shifted. As a result, the current ripples Ri output from the charge/discharge units 52 cancel out each other, and the combined current ripple SRi is reduced.

As has been described above, in the charge/discharge test system 10 according to the fourth embodiment, the switching phases of the charge/discharge units 52 based on the switching control system are shifted by 360°/N from each other. This allows a significant reduction in the combined current ripple SRi.

Here, the switching phases of the charge/discharge units 52 are shifted by 360°/N from each other in the fourth embodiment. However, the combined current ripple SRi may be reduced to some extent as long as the switching phases of the charge/discharge units 52 are not match each other. For this reason, the magnitude of the amount of shift between the switching phases of the charge/discharge units 52 is not particularly limited. When a shift amount is set at 360°/N, the combined current ripple SRi may be minimized as described in the second embodiment.

In the charge/discharge test system 10 according to the fourth embodiment, a plurality of charge/discharge units 52 are electrically connected in parallel to one charge/discharge target 9 via the DC bus 56. However, a plurality of charge/discharge units 52 may be electrically connected in parallel to each of the charge/discharge targets 9 via the DC bus 56 (see reference character 3A in Figure 3).

### [Fifth Embodiment]

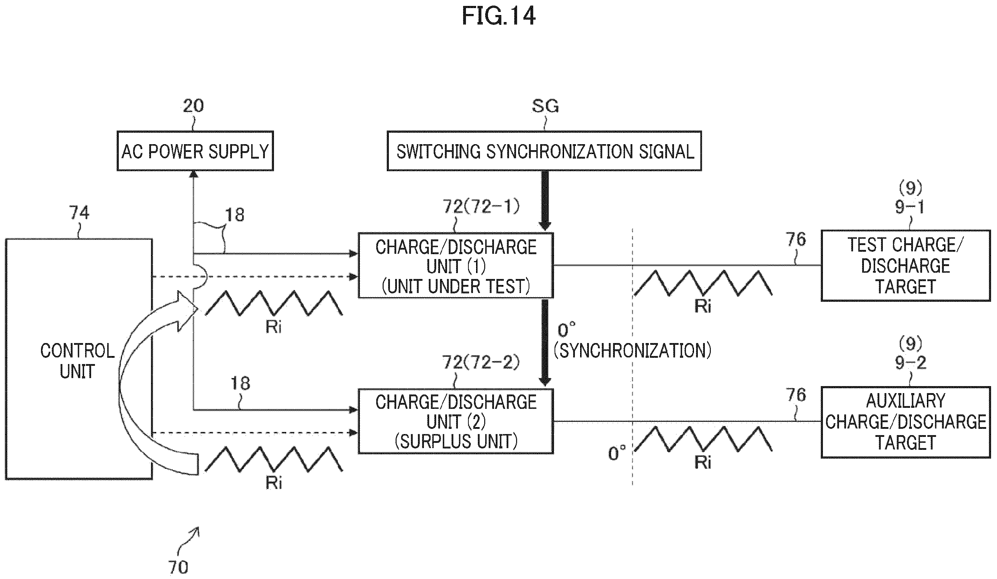

Figure 14 is a schematic diagram of a charge/discharge test system 70 according to a fifth embodiment. As shown in Figure 14, the charge/discharge test system 70 according to the fifth embodiment includes a plurality of charge/discharge units 72 and a control unit 74. Each charge/discharge unit 72 here may be, for example, a charge/discharge test device or a bidirectional DC/DC converter. Note that, if the charge/discharge unit 72 is a bidirectional DC/DC converter, a bidirectional AC/DC converter (not shown) is arranged between an AC power supply and the bidirectional DC/DC converter, as shown in Figure 9 or 10.

Two charge/discharge units 72 are provided, as indicated by the parenthesized numbers (1) and (2) in the third embodiment. The charge/discharge units 72 execute charging and discharging of two charge/discharge targets 9 (a test charge/discharge target 9-1 and an auxiliary charge/discharge target 9-2) under control of the control unit 74 (to be described later). Note that the number of charge/discharge units 72 may be three or more.

One ends of the charge/discharge units 72 are electrically connected to an AC power supply 20 via an AC bus 18, as in the first embodiment. The other ends, which is on the opposite side from the one ends, of the charge/discharge units 72 are electrically connected to the charge/discharge targets 9 via a DC bus 76.

The test charge/discharge target 9-1 is electrically connected to the other end of one of the charge/discharge units 72 via the DC bus 76, and the auxiliary charge/discharge target 9-2 is electrically connected to the other end of the other charge/discharge unit 72 via the DC bus 76. Hereinafter, the charge/discharge unit 72 that is electrically connected to the test charge/discharge target 9-1 via the DC bus 76 will be referred to as a "unit under test 72-1" as appropriate, and the charge/discharge unit 72 that is electrically connected to the auxiliary charge/discharge target 9-2 via the DC bus 76 will be referred to as a "surplus unit 72-2" as appropriate. Note that the test charge/discharge targets 9-1 may be electrically connected to the other ends of all the charge/discharge units 72 via the DC bus 76.

Each charge/discharge unit 72 is basically the same in configuration as the charge/discharge test device 12 according to the first embodiment. Each charge/discharge test device 72 executes: AC/DC conversion to convert AC power input from the AC power supply 20 via the AC bus 18 into DC power; and DC/DC conversion to decrease a high voltage of the DC power. Then, each charge/discharge test device 72 outputs the DC power with decreased voltage to the charge/discharge target 9 (the test charge/discharge target 9-1 or the auxiliary charge/discharge target 9-2) via the DC bus 56.

Each charge/discharge unit 72 also executes: DC/DC conversion to increase low voltage of DC power input from the charge/discharge target 9; and DC/AC conversion that converts the DC power with increased voltage into AC power. Then, each charge/discharge unit 72 regeneratively returns the AC power to the AC power supply 20 or outputs the AC power to another charge/discharge unit 72, via the AC bus 18. Note that each charge/discharge unit 72 may execute only DC/DC conversion.

A PLC or a combination of a PLC and a PC or a terminal other than a PC is used as the control unit 74, as in the above-described embodiments. The control unit 54 is electrically connected to the charge/discharge units 72.

The control unit 74 outputs a charge/discharge command to the unit under test 72-1 on the basis of a charge/discharge pattern for the test charge/discharge target 9-1 that is input in advance by an operator. Thus, the unit under test 72-1 executes charging and discharging of the test charge/discharge target 9-1 in accordance with the charge/discharge command.

In executing charging of the test charge/discharge target 9-1, the control unit 74 executes power supply from the auxiliary charge/discharge target 9-2 to the test charge/discharge target 9-1. Thus, power output from the auxiliary charge/discharge target 9-2 via the DC bus 76 and the surplus unit 72-2 is charged into the test charge/discharge target 9-1 via the AC bus 18, the unit under test 72-1, and the DC bus 76.

On the contrary, in executing discharging of the test charge/discharge target 9-1, the control unit 74 executes charging of the auxiliary charge/discharge target 9-2. Thus, power output from the test charge/discharge target 9-1 via the DC bus 76 and the unit under test 72-1 is charged into the auxiliary charge/discharge target 9-2 via the AC bus 18, the surplus unit 72-2, and the DC bus 76. This allows a reduction in power supply from the AC power supply 20 and a reduction in surplus power to be regeneratively returned to the AC power supply 20. It is thus possible to enhance power utilization efficiency of the charge/discharge test system 70.

The control unit 74 synchronizes switching control of charging of the charge/discharge target 9 (the test charge/discharge target 9-1 or the auxiliary charge/discharge target 9-2) by either one of the two charge/discharge units 72 (the unit under test 72-1 and the surplus unit 72-2), with switching control of discharging of the charge/discharge target 9 (the auxiliary charge/discharge target 9-2 or the test charge/discharge target 9-1) by the other.

For example, in the example shown in Figure 14, the control unit 74 synchronizes switching control of discharging of the auxiliary charge/discharge target 9-2 by the surplus unit 72-2 with switching control of charging of the test charge/discharge target 9-1 by the unit under test 72-1. This allows synchronization of output (discharging) of a current ripple Ri from the surplus unit 72-2 toward the AC bus 18 with output (charging) of a current ripple Ri from the unit under test 72-1 toward the DC bus 76. It is thus possible to reduce the current ripple Ri (output current ripple) output from the surplus unit 72-2. The reduction in the current ripple Ri allows a loss reduction, a reduction in heat generation of a cable, and prolongation of fuse life.

### [Others]

The above-described embodiments may be appropriately combined and carried out.

### Reference Signs List

9 charge/discharge target
9-1 test charge/discharge target
9-2 auxiliary charge/discharge target
9a charge/discharge target
10 charge/discharge test system
12 charge/discharge test device
12A surplus unit
13 measurement unit
14 switching circuit
14a port
14b port
16 control unit
18 AC bus
20 AC power supply
30 correction value acquisition controlling unit
32 charge/discharge test controlling unit
34 correction unit
40 charge/discharge test system
42 charge/discharge test system
50 charge/discharge test system
52 charge/discharge unit
52-1 master unit
52-2 slave unit
54 control unit
56 DC bus
70 charge/discharge test system
72 charge/discharge unit
72-1 unit under test
72-2 surplus unit
74 control unit
76 DC bus
121 bidirectional AC/DC converter
122 bidirectional DC/DC converter
D1 combination command signal
D2 correction condition switching command signal
D3 charge/discharge command
D3A charge/discharge command
D3B parallel signal
Ri current ripple
SG switching synchronization signal
SRi combined current ripple

## Claims

1. A charge/discharge test system comprising:
a plurality of charge/discharge units configured to perform charging and discharging of charge/discharge targets;
a switching circuit capable of switching between combinations of electrical connection between one or more of the charge/discharge units and one or more of the charge/discharge targets; and
a control unit configured to control the switching circuit to switch between the combinations.

2. The charge/discharge test system according to claim 1, wherein the switching circuit is capable of switching to a combination of electrical connection between one or more of the charge/discharge units and a same one of the charge/discharge targets.

3. The charge/discharge test system according to claim 1 or 2, comprising:
measurement units respectively provided for the charge/discharge units, and configured to measure at least any of voltages of the charge/discharge targets and currents flowing through the charge/discharge units;
a correction value acquisition controlling unit configured to acquire, for each of the combinations, correction values for correcting measurement values by the measurement unit; and
a correction unit configured to select correction values corresponding to a combination in the switching circuit from among the correction values for each of the combinations acquired by the correction value acquisition controlling unit, and correct the measurement value based on the selected correction values.

4. The charge/discharge test system according to claim 1 or 2, wherein
one ends of the charge/discharge units are electrically connected to each other via a bus, and the other ends of the charge/discharge units are connected to the switching circuit,
the control unit controls the charge/discharge units which are electrically connected to the charge/discharge targets via the switching circuit, to control charging and discharging of the charge/discharge targets, and
the control unit charges power output from one or more of the charge/discharge targets to be discharged via the switching circuit and the charge/discharge unit, into chargeable one or more of the charge/discharge targets via the bus, the one or more of the charge/discharge units and the switching circuit.

5. The charge/discharge test system according to claim 4, wherein
in a case where the charge/discharge targets connected to the other end of the switching circuit include: one or more test charge/discharge targets which are charge/discharge targets to be subjected to charge/discharge test; and one or more auxiliary charge/discharge targets which are charge/discharge targets other than the test charge/discharge targets, the control unit switches the switching circuit to a combination of electrical connection between charge/discharge units and a same one of the auxiliary charge/discharge targets.

6. A charge/discharge test system comprising:
a plurality of charge/discharge units configured to perform charging and discharging of a same charge/discharge target in a state where the plurality of charge/discharge units are connected in parallel to a same one charge/discharge target, the plurality of charge/discharge units configured to control magnitude of output current with a switching control system; and
a control unit configured to make respective switching phases of the plurality of charge/discharge units different from each other.

7. The charge/discharge test system according to claim 6, wherein
the control unit shifts the respective switching phases of the charge/discharge units by 360°/N from each other, wherein N (N is a natural number equal to or more than 2) represents a number of the charge/discharge units.

8. The charge/discharge test system according to claim 6 or 7, wherein the plurality of charge/discharge units make the switching phases different from each other based on a synchronization signal input from the control unit.
